# EUROPÄISCHE PATENTSCHRIFT

(11) **EP 0 342 621 B1**
(45) Veröffentlichungstag und Bekanntmachung des Hinweises auf die Patenterteilung: **31.03.1993**
(21) Anmeldenummer: 89108819.7
(22) Anmeldetag: 17.05.1989
(51) Int. Cl.: C25D 5/08, C25D 17/00, H05K 3/00

(54) **Tauchverfahren und Vorrichtung zum elektrolytischen Beschichten von Platten, insbesondere von elektrischen Leiterplatten**
Immersion process and apparatus for electroplating boards, particularly electric printed-circuit boards
Méthode d'immersion et dispositif de revêtement électrolytique de plaques, notamment de cartes de circuits imprimés

(30) Priorität: 17.05.1988 DE 3824260
(43) Veröffentlichungstag der Anmeldung: 23.11.1989
(73) Patentinhaber: STOHRER-DODUCO GmbH & Co., D-71277 Rutesheim (DE)
(72) Erfinder: Steins, Helmut, D-7263 Bad Liebenzell (DE)
(74) Vertreter: Twelmeier, Ulrich, Dipl.Phys.

(56) Entgegenhaltungen:
- EP-A- 0 125 446
- WO-A-88/04700
- US-A- 4 443 304

## Beschreibung

Die vorliegende Erfindung bezweckt eine Verbesserung des in der WO 88/04 700 offenbarten Verfahrens, und zwar soll die starke Streuung, die beim elektrolytischen Beschichten von Platten an den Plattenkanten auftreten kann, gemindert werden. Die Lösung dieser Aufgabe ist Gegenstand des Anspruchs 1 dieser Patentanmeldung. Vorteilhafte Weiterbildungen dieses Verfahrens sind Gegenstand der Unteransprüche. Geeignete Vorrichtungen zur Durchführung des Verfahrens sind Gegenstand der Vorrichtungsansprüche. Die Vorrichtung mit stationären Anoden und mit den Düsen verfahrbaren Blenden zwischen den Anoden und den zu beschichtenden Platten ist besonders vorteilhaft. Damit werden wenigstens gleich gute Ergebnisse erzielt wie mit der in der WO 88/04 700 offenbarten Vorrichtung, wobei jedoch demgegenüber der Vorteil besteht, dass die Anoden wesentlich großflächiger ausgeführt werden können als in der Vorrichtung gemäss WO 88/04 700. Die größere Anordenfläche führt dazu, dass bei gleich großer Kathodenstromdichte die Anodenstromdichte reduziert ist. Damit ist auch die Wasserstoffproduktion im Anodenbereich reduziert, die Anoden werden weniger stark passiviert, die Anodenlöslichkeit ist besser und die Lebensdauer (Standzeit) der Anoden ist verbessert. Vorteilhaft ist ferner, dass die Anoden keine beweglichen Zuleitungen benötigen.

Als weiterer Vorteil kommt hinzu, dass sich durch mit den Düsen verfahrbare, relativ schmale Blenden vor längeren stationären Anoden eine günstigere Makroverteilung des elektrischen Feldes in der Ebene der zu beschichtenden Platten erzielen läßt als durch kurze, mit den Düsen mitverfahrbare Anoden. Das reversierende Andüsen der zu beschichtenden Platten hat auf die Mikroverteilung des elektrischen Feldes und damit auf die Abscheidebedingungen in Bohrungen der Platten nach wie vor einen sehr günstigen Einfluß. Hinsichtlich der Anordnung und der reversierenden Bewegung der gegen die zu beschichtenden Platten gerichteten Düsen wird ergänzend auf die Offenbarung in der WO 88/04 700 bezug genommen.

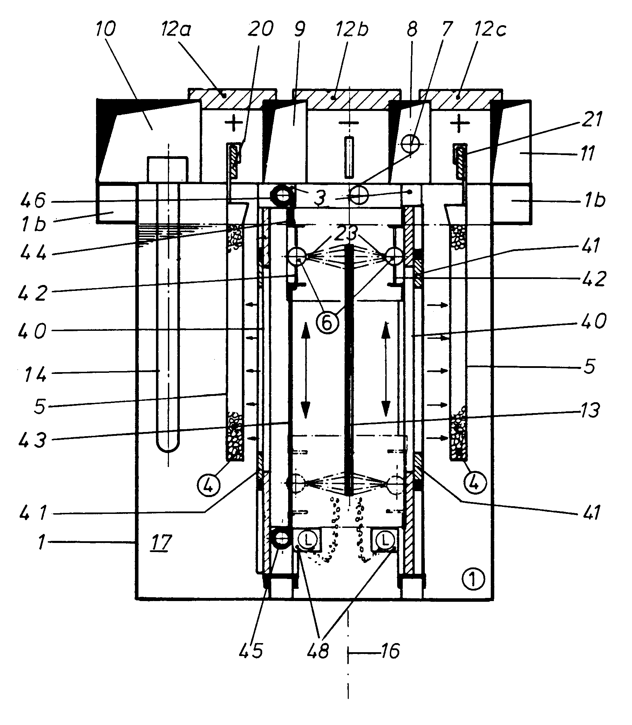

Zwei Ausführungsbeispiele der Erfindung sind in der beigefügten Zeichnung schematisch dargestellt.

Die Zeichnung zeigt eine Vorrichtung zum elektrolytischen Beschichten von Platten mit Metall in einem vertikalen Querschnitt.

Die Vorrichtung weist einen quaderförmigen Behälter 1 mit einem versteiften Rand auf. Auf dem Behälter 1 verlaufen in Längsrichtung mit Abstand nebeneinander ein Installationskanal 10, von dem aus z.B. ein Heizstab 14 und/oder Meßfühler zur Überwachung des Zustandes der in den Behälter eingefüllten Elektrolytflüssigkeit in den Behälter 1 eintauchen, ein Absaugkanal 9 zum Absaugen von verdampfter Elektrolytflüssigkeit, ein Schutzkasten 8 für eine Antriebswelle 7 und ein Abschlußkasten 11. Dazwischen sind drei abnehmbare Deckel 12a, 12b und 12c angeordnet, durch welche das Innere des Behälters 1 zugänglich ist.

Eine kathodisch gepolte Platte 13 oder eine durch eine Halterung gehaltene ebene Anordnung mehrerer solcher Platten, bei denen es sich um Vorprodukte für elektrische Leiterplatten handeln kann, ist in einer vorgegebenen Ebene 16 mitten unter dem mittleren Deckel 12b senkrecht in den Behälter 1 eingehängt. Die Ausbildung der Halterung für solche Platten 13 ist Stand der Technik und aus Gründen der Übersichtlichkeit nicht im einzelnen dargestellt.

Unterhalb der beiden äußeren Deckel 12a und 12c befinden sich zwei Anodenschienen 20 und 21, an welchen Anoden 4 hängen, welche z.B. durch Titankörbe 5 mit einer aus Kupferkugeln bestehenden Füllung gebildet sind.

Zwischen den Anoden 4 und der Ebene 16, in welcher die Platten 13 beim elektrolytischen Beschichten angeordnet sind, ist beidseits der Ebene 16 ein Diaphragma 40 angeordnet, welches in einer vertikalen Ebene verläuft und durch einen Rahmen 41 gebildet ist, welcher mit einem Kunststoffgewebe, z.B. aus Polypropylen, bespannt ist. Der Rahmen 41 besteht ganz oder teilweise aus Metall und hat die Funktion einer stationären Blende, welche das von den Anoden 4 ausgehende elektrische Feld teilweise abschirmt und die Fläche begrenzt , auf der in der Ebene 16 eine Metallabscheidung stattfinden kann.

Beidseits der Ebene 16 ist zwischen dieser und dem Diaphragma 40 ein Rohr 6 angeordnet, welches waagerecht und parallel zur Ebene 16 verläuft und hintereinander eine Anzahl von Düsen 23 hat, die gegen die Ebene 16 gerichtet sind. Alternativ können auf jeder Seite der Ebene auch mehr als zwei Zeilen von Düsen 23 übereinander und vorzugsweise in Richtung senkrecht zur Zeichenebene gegeneinander versetzt angeordnet sein. Die Düsen 23 befinden sich auf einem Schlitten 42, welcher mittels eines Motors im Behälter 1 senkrecht auf und ab verfahrbar ist.

Am unteren Teil des Rahmens 41 des Diaphragmas ist jeweils eine Rohrleitung 48 angeordnet, welche auf ihre Länge verteilt eine Anzahl von Öffnungen hat, durch die Luft in die Elektrolytflüssigkeit eingeleitet werden kann, die in Form von Luftblasen an den Platten 13 entlang hochsteigt. Das Einleiten von Luft ist für manche Elektrolytzusammensetzungen von Vorteil.

Bei der zeichnerisch dargestellten Vorrichtung ist der auf einer Seite der Ebene 16 liegende Schlitten 42 mit zwei Tüchern 43 und 44 verbunden, welche aus einem Kunststoffgewebe bestehen, insbesondere aus Polypropylen. Das eine Tuch 43 ist mit seinem einen Ende an der Unterseite des Schlittens 42 befestigt und mit seinem anderen Ende an einer unten im Behälter 1 angebrachten Rolle 45 aufgewickelt. Das andere Tuch 44 ist mit seinem einen Ende an der Oberseite des Schlittens 42 befestigt und mit seinem anderen Ende an einer oben im Behälter angebrachten zweiten Rolle 46 befestigt und aufgewickelt. Bewegt sich der Schlitten 42 nach unten, wird das obere Tuch 44 von der Rolle 46 abgewickelt und nach unten gezogen und gleichzeitig das untere Tuch 43 auf die untere Rolle 45 aufgewickelt. Fährt der Schlitten 42 nach oben, wird umgekehrt das untere Tuch 43 von der unteren Rolle 45 abgewickelt und nach oben gezogen und gleichzeitig das obere Tuch 44 auf die obere Rolle 46 aufgewickelt. Damit die Tücher 43 und 44 stets straff sind, kann man die Rollen 45 und 46 mittels Rutschkupplung und Elektromotor antreiben oder einfach einen Federmechanismus vorsehen, welcher bestrebt ist, beide Tücher auf ihre jeweilige Rolle aufzuwickeln, so dass das Abwickeln von der jeweiligen Rolle nur unter Überwindung der Federkraft erfolgen kann.

Der Schlitten 42, bei dem es sich am besten um eine offene Rahmenkonstruktion handelt, hat auf diese Weise zugleich die Funktion einer synchron mit den Düsen 23 mitverfahrbaren Blende, deren Wirkung ausreicht, um die sonst starke Streuung an den Plattenkanten hinreichend zu vermindern. Im übrigen kann das elektrische Feld zwischen den Anoden 4 und den kathodisch gepolten Platten 13 durch die offene Rahmenkonstruktion des Schlittens 42 um das Düsenrohr 6 herum hindurchgreifen.

Die dargestellte Anordnung mit einer auf und ab verfahrbaren Blende auf der einen Seite und mit lediglich einer stationären Blende 40 auf der anderen Seite der Ebene 16 ist vor allem einsetzbar für das nur einseitige Beschichten von Platten 13. Sollen Platten beidseitig beschichtet werden, empfiehlt es sich, zur Schaffung von im wesentlichen übereinstimmenden elektrischen Feldverhältnissen auf beiden Seiten der Ebene 16 entweder auf beiden Seiten der Ebene 16 nur jeweils eine stationäre Blende 41 oder anstelle solcher stationären Blenden, vorzugsweise jedoch in Kombination mit ihnen, schmalere, auf und ab verfahrbare Blenden vorzusehen, wie sie durch den auf und ab verfahrbaren Schlitten mit daran angebrachten Diaphragma-Tüchern 43 und 44 gebildet sind.

## Patentansprüche

1. Tauchverfahren zum elektrolytischen Beschichten von ruhenden Platten, insbesondere von elektrischen Leiterplatten, mit Metall in einem mit einem Elektrolyten angefüllten Behälter, in welchen wenigstens eine Anode und mit Abstand zu dieser die kathodisch gepolten Platten eintauchen, an deren Oberfläche durch unterhalb der Elektrolytoberfläche erzeugte und gegen die Platten gerichtete Elektrolytstrahlen eine Elektrolytströmung erzeugt wird, durch welche das Metall nicht auf allen kathodisch gepolten Bereichen der Platten zugleich, sondern wiederholt in über die Platten wandernden Bereichen abgeschieden wird und zu diesem Zweck die Elektrolytstrahlen die Platten überstreichen, wobei das zwischen der bzw. den Anoden und den kathodisch gepolten Platten bestehende elektrische Feld durch mit den Elektrolytstrahlen mitwandernde Blenden abgeschirmt wird, dadurch gekennzeichnet, dass das elektrische Feld durch die Blenden ausserhalb eines die Elektrolytstrahlen umgebenden Bereichs geschwächt oder sogar völlig ausgeblendet wird.

2. Verfahren nach Anspruch 1, dadurch gekennzeichnet, dass die Elekrolytstrahlen die Platten hin- und hergehend überstreichen.

3. Verfahren nach Anspruch 1 oder 2, dadurch gekennzeichnet, dass die Elektrolytstrahlen senkrecht gegen die Platten gerichtet werden.

4. Verfahren nach Anspruch 1, 2 oder 3, dadurch gekennzeichnet, dass Elektrolytstrahlen von beiden Seiten gegen die Platten gerichtet werden.

5. Verfahren nach Anspruch 4, dadurch gekennzeichnet, dass die Elektrolytstrahlen in der Weise versetzt gegen die Platten gerichtet werden, dass, wenn auf einer Seite einer Platte an einer Stelle ein Elektrolytstrahl auftrifft, an der genau gegenüberliegenden Stelle auf der anderen Seite der Platte nicht gleichzeitig ein Elektrolytstrahl auftrifft.

6. Verfahren nach einem der Ansprüche 1 bis 5, dadurch gekennzeichnet, dass auf jeder der zu beschichtenden Seiten der Platten zwei parallele Zeilen von Elektrolytstrahlen gebildet werden, die rechtwinklig zum Verlauf der Zeilen parallel zu den Platten hin- und hergehend über diese hinwegbewegt werden.

7. Verfahren nach Anspruch 6, dadurch gekennzeichnet, dass die Zeilen waagerecht verlaufen und die Platten lotrecht angeordnet werden.

8. Verfahren nach Anspruch 6 oder 7, dadurch gekennzeichnet, dass die Elektrolytstrahlen der einen Zeile bezogen auf die Bewegungsrichtung der Zeilen versetzt zu den Elektrolytstrahlen der anderen Zeile erzeugt werden.

9. Vorrichtung zum elektrolytischen Beschichten von Platten, insbesondere von elektrischen Leiterplatten, mit Metall nach einem Tauchverfahren,
mit einem Behälter zur Aufnahme eines Elektrolyten, in welchem wenigstens eine Anode angeordnet ist,
mit einer Halterung zum Eintauchen der kathodisch gepolten Platten in lotrechter Lage in den Elektrolyten,
mit unterhalb des Elektrolytspiegels im Behälter zwischen den Anoden und der für die Anordnung der Platten vorgesehenen Ebene angeordneten, gegen die eine und/oder die andere Oberfläche der Platten gerichteten Düsen, welche zum Vollführen einer wiederholt hin- und hergehenden Bewegung parallel zu der senkrechten Ebene im Behälter, die für die Anordnung der Platten vorgesehen ist, antreibbar sind, und denen durch eine Pumpe Elektrolytflüssigkeit zugeführt wird zum Erzeugen einer Elektrolytströmung,
und mit zwischen den Anoden und den Platten vorgesehenen Blenden zum Abschirmen des elektrischen Feldes, welche gemeinsam mit den Düsen verfahrbar sind,
dadurch gekennzeichnet,
dass die Blenden (41, 42, 43, 44) zwischen den Anoden (4), welche stationär angeordnet sind, und den Platten (13) nur eine die Düsen (23) umgebenden Bereich frei lassen.

10. Vorrichtung nach Anspruch 9, dadurch gekennzeichnet, dass die Düsen in oder an einem verfahrbaren Rahmen angeordnet sind, an welchem beidseits der Düsen eine flexible oder auf andere Weise aufrollbare, den Durchgriff des elektrischen Feldes schwächende oder verhindernde Jalousie (43, 44) befestigt ist.

11. Vorrichtung nach Anspruch 10, dadurch gekennzeichnet, dass die Jalousie einteilig, mit ihren beiden Enden an dem die Düsen tragenden Rahmen befestigt und ausserhalb des Verschiebeweges des Rahmens für die Düsen (23) über Umlenkrollen geführt ist.

12. Vorrichtung nach Anspruch 10, dadurch gekennzeichnet, dass die Jalousie zweiteilig ist und dass jeder Teil (43, 44) der Jalousie mit seinem einen Ende an dem Rahmen mit den Düsen (23) und mit seinem anderen Ende an einer Rolle (45, 46) befestigt ist, die die Jalousie aufwickelt und strafft.

13. Vorrichtung nach Anspruch 9, dadurch gekennzeichnet, dass die Düsen (23) in einer oder mehreren rechtwinklig zu ihrer Verschieberichtung verlaufenden Zeilen angeordnet sind.

14. Vorrichtung nach Anspruch 13, dadurch gekennzeichnet, dass auf einer Seite oder zu beiden Seiten der Ebene (16) im Behälter (1), die für die Anordnung der Platten (13) vorgesehen ist, zwei zueinander parallele Zeilen von Düsen (23) vorgesehen sind.

15. Vorrichtung nach Anspruch 14, dadurch gekennzeichnet, dass alle Düsen (23) den gleichen Abstand von der Ebene (16) im Behälter (1) haben, die für die Anordnung der Platten (13) vorgesehen ist.

16. Vorrichtung nach einem der Ansprüche 9 bis 15, dadurch gekennzeichnet, dass auf verschiedene Seiten der Ebene (16), die für die Anordnung der Platten (13) im Behälter (1) vorgesehen ist, liegende Düsen (23) so gegeneinander versetzt sind, dass keine Düse (23) einer anderen Düse (23) genau gegenüberliegt.

17. Vorrichtung nach Anspruch 14 oder nach Anspruch 15 und 16, dadurch gekennzeichnet, dass die Düsen (23) der einen Zeile von zwei benachbarten Zeilen, bezogen auf ihre Verschieberichtung,gegenüber den Düsen (23) der anderen Zeile versetzt angeordnet sind.

## Claims

1. A dipping process of electrodepositing metal on stationary plates, particularly electrical printed circuit boards, in a container which is filled with an electrolyte and in which at least one anode and the cathodically polarized plates spaced from the anode are immersed and an electrolyte flow is produced on the surface of the plates by electrolyte jets, which are generated below the surface of the electrolyte and directed against the plate, by which electrolyte flow the metal is not deposited on all cathodically polarized regions of the plate at the same time but is repeatedly deposited in regions travelling over the plates, and the electrolyte jets sweep the plates for that purpose,wherein the electric field existing between the anode or anodes and the cathodically polarized plate is shielded by shields, which travel with the elctrolyte jets, characterized in that the electric field is weakened or even entirely masked outside a region which surrounds the electrolyte jets.

2. A process according to claim 1, characterized in that the electrolyte jets reciprocate as they sweep the plates.

3. A process according to claim 1 or 2, characterized in that the electrolyte jets are directed to the plates at right angles thereto.

4. A process according to claim 1, 2 or 3, characterized in that electrolyte jets are directed against the plates from both sides.

5. A process according to claim 4, characterized in that the electrolyte jets are directed against the plates in such a staggered arrangement that when an electrolyte jet impinges on a plate on one side at a point the plate is not impinged by an electrolyte jet on the other side at an exactly opposite point.

6. A process according to any of claims 1 to 5, characterized in that two parallel rows of electrolyte jets are formed on each of the sides on which the plates are to be coated and said rows are reciprocated over the plates at right angles to the direction of the lines.

7. A process according to claim 6, characterized in that the lines are horizontal and the plates are vertically arranged.

8. A process according to claim 6 or 7, characterized in that the electrolyte jets of one line are offset from the electrolyte jets of the other row in the direction of movement of the rows.

9. An apparatus for the electrodeposition of metal on plates, particularly on electric printed circuit boards, by a dip process, comprising
a container for holding an electrolyte, in which at least one anode is disposed,
a holder for immersing the cathodically polarized plates in a vertical position into the electrolyte,
nozzles, which are disposed in the container below the electrolyte level between the anodes and the plane in which the plates are intended to be disposed and which are directed towards one and/or the other surface of the places and are adapted to be driven to perform a repetitive reciprocating motion which is parallel to that vertical plane in which the plates are intended to be disposed in the container, which nozzles are supplied from a pump with liquid electrolyte for producing an electrolyte flow, and
shields, which are provided between the anodes and the plates and serve to shield the electric field and are movable in unison with the nozzles,
characterized in that
the shields (41, 42, 43, 44) leave free only a region surrounding the nozzles (23) between the stationary anodes (4) and the plates (13).

10. An apparatus according to claim 9, characterized in that the nozzles are provided in or on a movable frame and a blind which is flexible or can otherwise be rolled up and weakens or prevents the action of the electric field is secured to said frame on both sides of the nozzles.

11. An apparatus according to claim 10, characterized in that the blind is integral and is secured at its both ends to the frame which carries the nozzles and the blind is trained around deflecting rollers outside the path along which the frame for the nozzles (23) is displaced.

12. An apparatus according to claim 10, characterized in that the blind is bipartite and each part (43, 44) of the blind is secured at one end to the frame provided with the nozzles (23) and at its other end to a roller (45, 46), which serves to wind up and tension the blind.

13. An apparatus according to claim 9, characterized in that the nozzles (23) are arranged in one row or in one or more rows, which extend at right angles to the direction in which the nozzles are displaced.

14. An apparatus according to claim 13, characterized in that two parallel rows of nozzles (23) are provided on one side or on both sides of that plane (16) in which the plates (13) are intended to be arranged in the container (1).

15. An apparatus according to claim 14, characterized in that all nozzles (23) are spaced the same distance from that plane (16) in which the plates (13) are intended to be arranged.

16. An apparatus according to any of claims 9 to 15, characterized in that nozzles (23) which are disposed on different sides of the plane (16) in which the plates (13) are intended to be arranged in the container (1) are so offset from each other that no nozzle (23) exactly registers with another nozzle (23).

17. All apparatus according to claim 14 or according to claims 15 and 16, characterized in that the nozzles (23) of one row of two adjacent rows are offset in the direction in which they are displaced from the nozzles (23) of the other side.

## Revendications

1. Procédé d'immersion pour la métallisation électrolytique de plaques stationnaires, en particulier de plaques-circuits électriques imprimés, dans un récipient rempli d'un électrolyte dans lequel sont immergées au moins une anode et à une certaine distance de celle-ci les plaques à polarisation cathodique, sur la surface desquelles est créé un courant électrolytique sous l'effet de jets électrolytiques qui sont produits sous la surface de l'électrolyte et orientés vers les plaques, ce courant électrolytique ayant pour effet que le métal n'est pas déposé simultanément sur toutes les zones à polarisation cathodique des plaques mais de manière répétée dans des zones mobiles au-dessus des plaques et qu'à cette fin, les jets électrolytiques balaient lesdites plaques, tandis que le champ électrique constitué entre la ou les anodes et les plaques à polarisation cathodique est protégé à l'aide d'écrans qui se déplacent en même temps que les jets électrolytiques, caractérisé par le fait que sous l'effet des écrans, le champ électrique est affaibli, voire même totalement supprimé à l'extérieur d'une zone entourant les jets électrolytiques.

2. Procédé selon la revendication 1, caractérisé par le fait que les jets électrolytiques balaient les plaques en un mouvement de va-et-vient.

3. Procédé selon la revendication 1 ou 2, caractérisé par le fait que les jets électrolytiques sont orientés perpendiculairement contre les plaques.

4. Procédé selon la revendication 1, 2 ou 3, caractérisé par le fait que les jets électrolytiques provenant des deux côtés sont dirigés contre les plaques.

5. Procédé selon la revendication 4, caractérisé par le fait que les jets électrolytiques sont orientés contre les plaques de manière décalée, de telle sorte que sur une face d'une plaque, un jet électrolytique parvient à un point, aucun jet électrolytique ne frappant le point exactement opposé de l'autre face de la plaque.

6. Procédé selon l'une des revendications 1 à 5, caractérisé par le fait que sur chacune des faces des plaques à métalliser se forment deux lignes parallèles de jets électrolytiques qui effectuent un mouvement de va-et-vient sur les plaques et parallèlement à celles-ci en suivant un trajet formant un angle droit avec le parcours suivi par les jets.

7. Procédé selon la revendication 6, caractérisé par le fait que les lignes s'étendent horizontalement et que les plaques sont disposées verticalement.

8. Procédé selon la revendication 6 ou 7, caractérisé par le fait que par rapport à la direction du mouvement des lignes, les jets électrolytiques de l'une des lignes sont produits de manière décalée par rapport aux jets électrolytiques de l'autre ligne.

9. Dispositif pour la métallisation électrolytique de plaques, en particulier de plaques circuits électriques imprimés, selon un procédé d'immersion comprenant un récipient recevant un électrolyte dans lequel est disposé au moins une anode, comportant un support pour l'immersion des plaques à polarisation cathodique en position verticale dans l'électrolyte, comportant sous le niveau de l'électrolyte, à l'intérieur du récipient, entre les anodes et le plan prévu pour la disposition des plaques, des buses orientées vers l'une et/ou l'autre surfaces des plaques, ces buses pouvant être entrainées pour l'exécution d'un mouvement répété de va-et-vient parallèle au plan vertical prévu pour la disposition des plaques à l'intérieur du récipient et auxquelles un liquide électrolytique est amené au moyen d'une pompe afin de produire un courant électrolytique, et comportant entre les anodes et les plaques des écrans prévus pour protéger le champ électrique, lesquels sont mobiles en même temps que les buses, caractérisé par le fait que les écrans (41, 42, 43, 44) ne laissent libre qu'une zone entourant les buses (23) entre les anodes (4), qui sont stationnaires, et les plaques 13.

10. Dispositif selon la revendication 9, caractérisé par le fait que les buses sont disposées à l'intérieur ou sur un cadre mobile sur lequel des deux côtés desdites buses est fixé un rideau (43, 44) flexible ou pouvant être enroulé de toute autre manière, qui affaiblit ou supprime la pénétration du champ électrique.

11. Dispositif selon la revendication 10, caractérisé par le fait que le rideau est fixé d'une seule pièce, par ses deux extrémités sur le cadre supportant les buses, et qu'il est guidé sur des poulies de renvoi extérieurement au trajet de déplacement du cadre des buses (23).

12. Dispositif selon la revendication 10, caractérisé par le fait que le rideau est en deux parties et que chaque partie (43, 44) dudit rideau est fixée par l'une de ses extrémités sur le cadre comportant les buses (23) et par l'autre de ses extrémités sur une poulie (45, 46) qui enroule le rideau et le tend.

13. Dispositif selon la revendication 9, caractérisé par le fait que les buses (23) sont disposées en une seule ou en plusieurs lignes s'étendant perpendiculairement à leur direction de déplacement.

14. Dispositif selon la revendication 13, caractérisé par le fait que sur un côté ou sur les deux côtés du plan (16) prévu pour la disposition des plaques (13) et se trouvant à l'intérieur du récipient (1) sont prévues deux lignes de buses (23) parallèles l'une par rapport à l'autre.

15. Dispositif selon la revendication 14, caractérisé par le fait que toutes les buses (23) sont placées à une distance égale du plan (16) se trouvant à l'intérieur du récipient (1) et prévu pour la disposition des plaques (13).

16. Dispositif selon l'une des revendications 9 à 15, caractérisé par le fait que sur plusieurs côtés du plan (16) prévu à l'intérieur du récipient (1) pour la disposition des plaques (13) des buses (23) horizontales sont décalées les unes par rapport aux autres de telle sorte qu'aucune buse (23) ne se trouve exactement en face d'une autre buse (23).

17. Dispositif selon la revendication 14, ou selon les revendication 15 et 16, caractérisé par le fait que les buses (23) de l'une de deux lignes voisines sont décalées par rapport aux buses (23) de l'autre ligne en ce qui concerne la direction de leur déplacement.
